Europäisches Patentamt

European Patent Office

Office européen des brevets

(19)

(11) Veröffentlichungsnummer: **0 000 170**
**B1**

(12) **EUROPÄISCHE PATENTSCHRIFT**

(45) Veröffentlichungstag der Patentschrift: **20.01.82**

(21) Anmeldenummer: **78100197.9**

(22) Anmeldetag: **20.06.78**

(51) Int. Cl.³: **G 03 C 5/24, C 23 F 1/02,**
**G 01 B 11/14, H 01 L 21/00**

(54) Verfahren und Vorrichtung zur Steuerung von Entwicklungs- oder Ätzprozessen.

(30) Priorität: **23.06.77 DE 2728361**

(43) Veröffentlichungstag der Anmeldung:
**10.01.79 Patentblatt 79/1**

(45) Bekanntmachung des Hinweises auf die Patenterteilung:
**20.01.82 Patentblatt 82/3**

(84) Benannte Vertragsstaaten:
**DE FR GB**

(56) Entgegenhaltungen:
**US - A - 3 957 376**
**US - A - 4 039 370**

(73) Patentinhaber: **International Business Machines Corporation**
**Armonk, N.Y. 10504 (US)**

(72) Erfinder: **Moritz, Holger**
**Ulmenstrasse 118**
**D-7031 Holzgerlingen (DE)**

(74) Vertreter: **Teufel, Fritz (DE)**
**Schönaicher Strasse 220**
**D-7030 Böblingen (DE)**

Courier Press, Leamington Spa, England.

## Verfahren und Vorrichtung zur Steuerung von Entwicklungs- oder Ätzprozessen

Die Erfindung betrifft ein Verfahren zur Steuerung von Entwicklungsoder Ätzprozessen nach dem Oberbegriff von Anspruch 1 und eine Vorrichtung zur Steuerung von Entwicklungs- und Ätzprozessen nach dem Oberbegriff von Anspruch 9.

Bei der Herstellung von integrierten Schaltkreisen werden Halbleiterplättchen mit einer Photolackschicht überzogen und anschließend mit Hilfe von Masken mit einem meist sehr komplizierten und sehr fein strukturierten Muster belichtet. Wegen der immer höher werdenden Packungsdichten und weil die elektrischen Eigenschaften der das Endprodukt bildenden integrierten Schaltkreise in hohem Maße von der genauen Einhaltung der vorgegebenen Linienbreiten und Linienabstände der übertragenen Lichtmuster abhängig sind, werden an die Präzision der verwendeten Masken und an die während des Belichtungsvorganges einzuhaltenden Parameter höchste Anforderungen gestellt. Es hat sich gezeigt, daß die bei der Übertragung der Lichtmuster auftretenden, meist sehr engen Toleranzen durch den Entwicklungsvorgang und durch einen unter Umständen sich anschließenden Ätzvorgang in vielen Fällen so verschlechtert werden, daß die nach diesem Verfahren erzeugten integrierten Schaltkreise nur zu einem geringen Prozentsatz verwendbar sind. Die während eines Entwicklungs- oder Ätzvorganges eintretende Verschlechterung der Toleranzen ist unter anderem damit zu erklären, daß die Beleuchtungsstärke in den Randzonen eines belichteten Bereiches, beispielsweise eines linienförmigen Bereiches, selbst bei exaktester Ausleuchtung in der Regel wesentlich niedriger ist als in der Mitte. Das hat zur Folge, daß die. Beleuchtungsstärke als Funktion des Abstandes von der Linienmitte nicht einen rechteckförmigen Verlauf sodern einen allmählichen Abfall zu den Linienrändern hin aufweist, was zur Folge hat, da die Breite der durch eine Entwicklung oder eine Ätzung freigelegten Bereiche eine starke Abhängigkeit von der Entwicklungs- bzw. Ätzdauer hat. Selbst bei angenähert rechteckigem Verlauf der Belichtungsprofile kann die Breite der freigelegten Bereiche über die belichteten Bereiche hinaus durch ein sogenanntes "Unterätzen" unter Umständen ganz wesentlich vergrößert werden. Die oben angesprochenen hohen Anforderungen an die Genauigkeit der entwickelten oder geätzten Muster werden noch dadurch erhöht, daß bei der Herstellung einer integrierten Schaltung eine Vielzahl von Belichtungen in aufeinanderfolgenden Verfahrensschritten erforderlich ist.

Die Entwicklung der belichteten Photolackschicht wird üblicherweise durch genaue Einhaltung einer durch vorher durchzuführende Versuchsreihen ermittelten Entwicklungszeit gesteuert. Da aber neben der Zeit auch eine Reihe anderer Parameter, wie Konzentration, Reinheit und Temperatur des Entwicklers sowie Beschaffenheit, Reinheit und Dicke der Lackschichten, vor allem aber die Beleuchtungsstärke während der Belichtung der Photolackschichten von großem Einfluß auf die Dicke der freigelegten Linien sind, können trotz genauester Prozeßüberwachung Fehler nicht mit der erforderlichen Sicherheit ausgeschlossen werden.

Aus diesem Grund hat man daher in letzter Zeit Verfahren zur Steuerung von Ätzvorgängen auf die Steuerung des Entwicklungsvorganges übertragen. Es hat sich aber gezeigt, daß die bei der Überwachung und Steuerung von Ätzvorgängen verwendeten Verfahren eine Reihe von Nachteilen aufweisen, die sie bei Vorliegen von höchsten Anforderungen sowohl bei der Steuerung von Ätzvorgängen als auch bei der Steuerung von Entwicklungsvorgängen in vielen Fällen unbrauchbar machen. So wird beispielsweise in der Literaturstelle "IBM Technical Disclosure Bulletin", Vol. 18, No. 6, November 1975, Seiten 1867 bis 1870 ein Verfahren beschrieben, bei dem die Reflexion eines auf das Werkstück schräg einfallenden Lichtstrahls gemessen und als Kriterium für die Beendigung eines Entwicklungsoder Ätzvorganges ausgewertet wird. Es ist leicht einzusehen, daß bei diesem Verfahren nur der erste Durchbruch durch eine geätzte Schicht oder das Aufhören der Veränderung der Breite dieser Schicht, nicht aber das Vorliegen einer bestimmten Breite festgestellt werden kann. Das gleiche gilt für die in der Literaturstelle "IBM Technical Disclosure Bulletin", Vol. 15, No. 11, April 1973, Seiten 3532 und 3533 beschriebene Vorrichtung, bei der anstelle des reflektierten Lichtes das durch das Werkstück hindurchtretende Licht zur Anzeige der Beendigung des Ätzvorganges verwendet wird.

Ein Verfahren zur berührungslosen Messung des Abstands zweier Kanten, das auch zur laufenden Prozeßüberwachung verwendet werden kann, ist in der US-Patentschrift 3 957 376 beschrieben. Die zu messenden Kanten, die beispielsweise die Begrenzungslinien eines Leiterzugs auf einer Halbleiterschaltung sein können, werden mit parallelem monochromatischem Licht bestrahlt und die an den Kanten entstehende optische Beugungsfigur ausgewertet. Dazu wird mit Hilfe einer Kette aus Photodetektoren das gesamte Beugungsbild abgetastet und die Nullstellen der Beugung ermittelt. Der apparative Aufwand zur Durchführung dieses Verfahrens ist erheblich, da sowohl eine größere Anzahl von Photodetektoren als auch eine komlizierte Auswerteschaltung zur zweifelsfreien Bestimmung der Lage und der Art der Nullstellen erforderlich ist.

Die Erfindung geht von der Aufgabe aus, ein Verfahren zur Überwachung und Steuerung von Entwicklungs- und/oder Ätzvorgängen anzugeben, mit dessen Hilfe es bei niedrigem technischen Aufwand möglich ist, den Entwicklungs- oder Ätzprozeß bei Vorliegen genau definierter Linienbreiten abzubrechen und somit sogar bei der Belichtung eintretende Fehler weitgehend ausgleichen zu können. Diese Aufgabe wird durch die im Anspruch 1 beschriebene Erfindung gelöst.

Gegenüber den bisher bekannten Verfahren und Vorrichtungen hat das erfindungsgemäße Verfahren den Vorteil, daß anstelle einer Reihe von bei der Durchfürung eines Entwicklungs- oder Ätzprozesses erforderlicher, sehr exakter Messungen nur die Intensität einer oder mehrerer Beugungsordnungen gemessen werden muß. Aufgrund dieser Messung muß dann nur ein einziger Parameter, beispielsweise die Entwicklungszeit, geändert werden, um Änderungen eines oder mehrerer der oben erwähnten Parameter unschädlich zu machen. Anstelle von Meßungen und Steuerungen einer Vielzahl von Parametern wird dadurch nur die Messung einer Lichtintensität und die Steuerung eines einzigen Parameters erforderlich. Da die "in Situ" durchführbare Meßung nicht einen für das Endergebnis des Prozesses maßgeblichen Parameter, sondern das Endergebnis selbst, nämlich die Linienbreite, erfaßt, kann die Genauigkeit des erfindungsgemäßen Verfahrens trotz der Einfachheit der verwendeten Mittel durch keines der bisher vorgeschlagenen Verfahren auch nur angenähert erreicht werden.

Die Erfindung wird anschließend anhand der Figuren näher erläutert.

Es zeigen:

Fig. 1 die schematische Darstellung des bei Belichtung durch eine vorgegebene Maske auftretenden Intensitätsverlaufs und des nach Abschluß des Entwicklungsvorganges vorliegenden Verlaufs der Lackdicke.

Fig. 2 die schematische Darstellung eines Ausführungsbeispiels der Erfindung.

Fig. 3 die pespektivische Darstellung eines Ausschnittes des in Fig. 2 dargestellten Ausführungsbeispiels.

Fig. 4 den Verlauf der Intensität der Beugung zweiter Ordnung als Funktion der Entwicklungs- oder Ätzzeit.

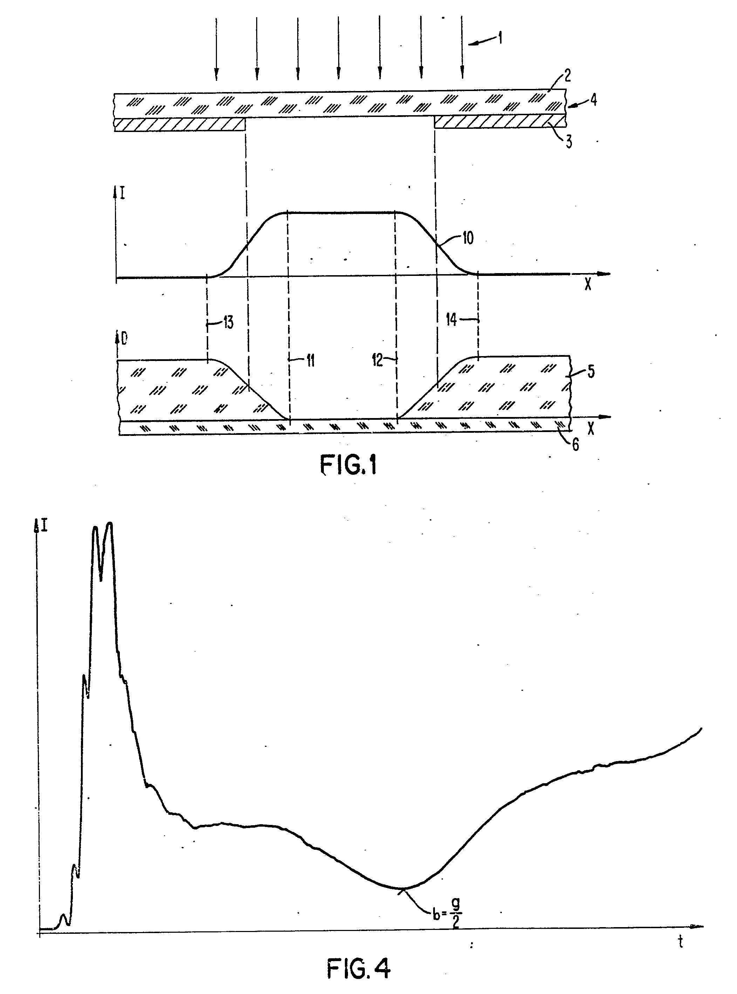

Anhand von Fig. 1 werden die Verhältnisse bei der Belichtung einer Photolackschicht durch eine Maske erläutert. Fällt, wie in Fig. 11 dargestellt, eine kollimierte Strahlung 1 auf eine aus einem durchsichtigen Trägerelement 2 und aus einem undurchsichtigen Bereich 3 bestehende Maske 4, so ergibt sich im Bereich einer Lackschicht 5, bedingt durch die in den Randbereichen der undurchsichtigen Schicht 3 auftretenden Beugungserscheinungen, der durch die Linie 10 dargestellte Intensitätsverlauf. Wird die so belichtete Lackschicht entwickelt, so wird nach einer vorgegebenen Zeit zunächst der zwischen den Linien 11 und 12 liegende Bereich eines unter der Lackschicht liegenden Halbleiterplättchens 6 fast gleichzeitig freigelegt. Es ist leicht einzusehen, daß die Breite dieses Bereiches mit der Breite des durchsichtigen Bereiches der Maske 4 nicht übereinstimmt und weitgehend durch Schwankungen der Intensität der Strahlung 1 verändert wird. Bei Fortsetzung des Entwicklungsprozesses wird nach einer nur experimentell ermittelbaren Zeit die Breite des freigelegten Bereiches des Halbleiterplättchens 6 der Breite des durchsichtigen Bereiches der Maske 4 gleich sein. Diese experimentell ermittelte Entwicklungszeit gilt aber nur, wenn alle anderen Parameter, nämlich die Intensität der Belichtung, die Dauer der Belichtung, die Konzentration, Reinheit und Temperatur des Entwicklers sowie die Zusammensetzung, die Reinheit und die Dicke der Photolackschicht mit großer Genauigkeit konstant gehalten werden können. Wird die Entwicklungszeit weiter vergrößert oder ändern sich die oben aufgezählten Parameter in einer bestimmten Richtung, so wird der freigelegte Bereich des Halbleiterplättchens 6 allmählich den granzen Bereich zwischen den Linien 13 und 14 einnehmen und, bei manchen Photolacken, nach einer weiteren Verlängerung der Entwicklungszeit durch "Unterätzen" der Lackschicht noch größer werden. Es ist leicht einzusehen, daß zu einer genauen Übertragung der durchlässigen Bereiche der Maske 4 eine ganze Reihe von zum Teil sehr schwer zu überwachenden Parametern mit größter Genauigkeit eingehalten werden muß. Jede Veränderung eines dieser Parameter kann zur Verkleinerung oder zur Vergrößerung der freigelegten Bereiche des halbleiterplättchens 6 führen, wodurch im schlimmsten Fall mehrere getrennt zu dotierende oder getrennt mit leitenden Überzügen zu versehende Bereiche miteinander verschmelzen oder zumindest einander so nahe kommen, daß die elektrischen Eigenschaften einer mit diesem Verfahren hergestellten Halbleiterschaltung ganz wesentlich verändert werden.

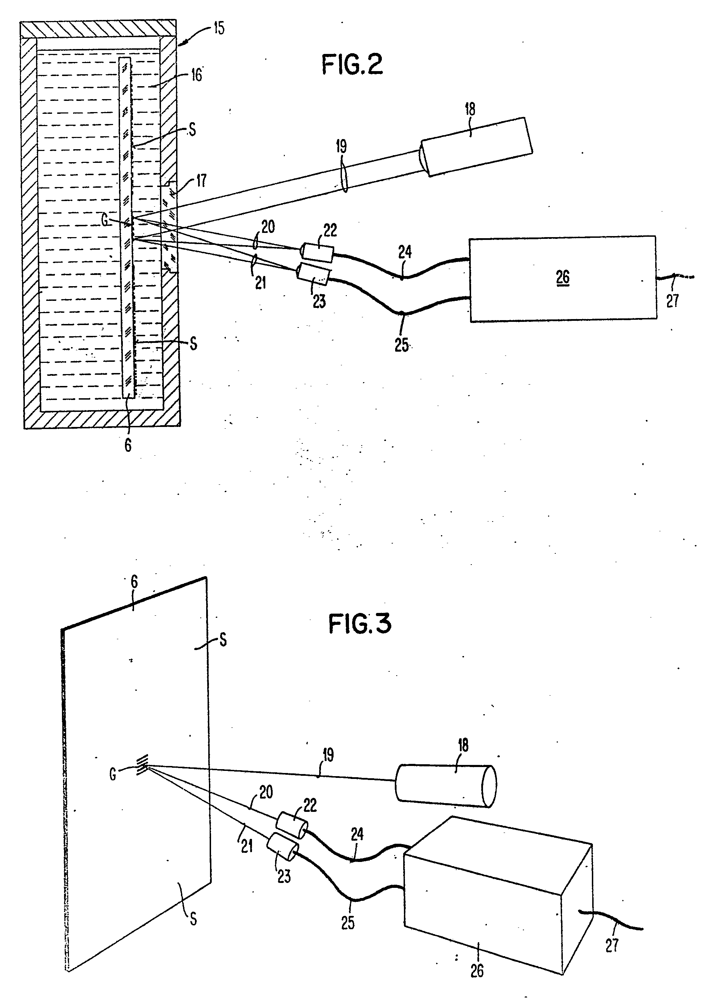

In Fig. 2 wird ein einfaches Ausführungsbeispiel der Erfindung schematisch und in Fig. 3 ein Auschnitt aus Fig. 2 perspektivisch dargestellt. Die Vorrichtung bestreht aus einem Gefäß 15, in dem ein Entwickler 16 untergebracht ist. Im Entwickler 16 befindet sich ein mit einer Photolackschicht überzogenes Halbleiterplättchen 6, das mit dem in Fig. 1 veranschaulichten Verfahren belichtet wurde. Die mit S bezeichneten und im verkleinerten Maßstab dargestellten Bereiche des Halbleiterplättchens 6 und der darauf befindlichen Photolackschicht wurden mit einem Muster belichtet, das die zum Aufbau einer Integrierten Schaltung in unterschiedlicher Weise dotierten oder mit leitenden Schichten überzogenen Bereiche und Linienstrukturen enthält. Der mittlere, mit G bezeichnete Bereich des Halbleiterplättchens und die darauf befindliche Photolackschicht wurde mit einem Muster belichtet, das aus einer Anzahl von vorgegebene Breiten und Abstände voneinander aufweisenden Linien besteht. Die Breite der Linien und der Abstände zwischen den einzelnen Linien des Gitters entsprechen in der Regel der mittleren Breite der Linien und der Abstände zwischen den Linien in den Bereichen S. Diese Breiten und Abstände können aber auch größer kleiner als die Breiten und Abstände der Linien im Bereich S gewählt werden. Ferner ist eine Lichtquelle 18 zur Erzeugung eines monochromatischen kollimierten Lichtstrahls 19 vorgesehen, der durch ein Fenster 17 des Gefäßes 15 auf den mit einer Gitterstruktur belichteten Bereich G des Halbleiterplättchens fällt. Die Vorrichtung besteht weiterhin aus zwei Lichtdetektoren 22 und 23, die in der Richtung der zweiten und dritten Beugungsordnung der auf das im Bereich G durch die Entwicklung entstehende Gitter fallenden Strahlung 19 liegen.

Die Orte der Lichtdetektoren 22 und 23 sind eine eindeutige Funktion der Gitterkonstante g des im Bereich G entstehenden Gitters. Während die Lage der Beugungsordnungen bei vorgegebener Richtung und bei vorgegebener Wellenlänge der Strahlung 19 eine eindeutige Funktion der Gitterkonstante g, also prozeßunabhängig ist, ist der Intensität dieser Beugungsordnungen eine eindeutige Funktion der Breite der durch den Entwicklungsvorgang freigelegten Linienbereiche. Wird während des Entwicklungsvorganges die Breite b der durch den Entwicklungsvorgang freigelegten Bereiche zwischen den Gitterlinien gleich der halben Gitterkonstante g, die Linienabstände also gleich den Linienbreiten, so wird, wie aus der Beaugungsoptik bekannt, die Intensität des Beugungsmaximums zweiter Ordnung gleich O. Da die Flanken der Gitterlinien nicht exakt senkrecht sind, wird in der Praxis die Intensität der zweiten Beugungsordnung nicht gleich O, sondern durchläuft ein Minimum. Der Verlauf dieser Intensität wird in Fig. 4 als Funktion der Entwicklungszeit schematisch dargestellt. Bei extrem fein strukturierten Lichtmustern, bei denen die Linienbreiten und Linienabstände an der Grenze des optischen Auflösungsvermögens liegen, kann es vorteilhaft sein, die Linienbreiten und Linienabstände des zur Prozeßsteuerung verwendeten Gitters größer zu machen, um zu vermeiden, daß bei dem sich in diesem Fall möglicherweise ergebenden sinusähnlichen Gittern der Intensitätsverlauf im Bereich der zweiten Beugungsordnung oder im Bereich anderer Beugungsordnungen verfälscht wird. Es hat sich herausgestellt, daß für jede Linienbreite eines zu übertragenden Schaltungsmusters eine optimale Gitterkonstante experimentell ermittelt werden kann, bei der das Minimum bestimmter Beugungsordnungen ein eindeutiges Kriterium für die Beendigung des Entwicklungsvorganges für das belichtete Schaltungsmuster ist. Weisen die durch Belichtung der Photolackschicht übertragenen Schaltungsmuster sehr große Linienbreiten und Linienabstände auf, kann es zweckmäßig, sein, die Gitterkonstante kleiner zu machen und dadurch die Empfindlichkeit Anzeige zu erhöhen.

Ist der Entwicklungsvorgang weit genug fortgeschritten und beginnt das im Bereich G belichtete Gitter sich allmählich auzzubilden, so wird im Bereich der beispielsweise durch den Strahl 20 angedeuteten Richtung der zweiten Beugungsordnung, wei in Fig. 4 angedeutet, zunächst kein Licht vorliegen. Bei forschreitender Ausbildung der Gitterstrucktur, nämlich bei allmählichem Breiterwerden der einzelnen Gitterlinien, wird die Intensität im Bereich der zweiten Beugungsordnung sehr rasch ansteigen, um dann wieder schnell abzufallen. Wird die Breite der freigelegten Bereiche gleich der halben Gitterkonstante, so wird ein Minimum erreicht. Bei Fortsetzung des Ätzvorganges wird die Breite der freigelegten Bereich größer als die halbe Gitterkonstante, so daß die Intensität der Strahlung im Bereich der zweiten Beugungsordnung allmählich ansteigt. Dieser Verlauf der Intensität der zweiten Beugungsordnung wird durch den Lichtdetektor 22 in elektrische Signale umgewandelt, die über eine Leitung 24 zu einer Auswertschaltung 26 übertragen werden. Zur Erhöhung der Meßgenauigkeit kann es sinnvoll sein, einen weiteren Lichtdetektor 23 im Strahlengang 21 der dritten Beugungordnung anzuordnen, der den Intensitätsverlauf dieser Beugungsordnung in elektrische Signale umwandelt und über eine Leitung 25 zur Auswertschaltung 26 überträgt. Die Auswertschaltung 26 ist so ausgelegt, daß bei Erreichen bestimmter Intensitätswerte im Bereich einer oder mehrerer Beugungsordnungen auf einer Ausgangsleitung 27 ein den Entwicklungsvorgang beendendes Signal auftritt.

Die Erfindung ist selbstverständlich nicht auf durch Masken oder sonstige zu reproduzierende körperliche Vorlagen übertragene Muster beschränkt. Sie kann vielmehr auch im Zusammenhang mit durch sogenannte "Artwork"- Generatoren, die beispielsweise als Licht- oder Elektronenstrahlschreiber ausgebildet sein können, erzeugte Muster verwendet werden.

**Patentansprüche**

1. Verfahren zur Steuerung von Entwicklungs- oder Ätzprozessen an einem Werkstück, das mit einem Bündel parallen monochromatischen Lichts bestrahlt wird und eine Beugungsfigur erzeugt, deren Intensität gemessen wird, dadurch gekennzeichnet, daß zusätzlichzu dem zu entwickelnden oder zu ätzenden Muster ein latentes, in gleicher Weise wiedas Muster entwickel- oder ausätzbares Gitter auf das Werkstück aufgebracht wird, daß Muster und Gitter gemeinsam entwickelt oder geätzt werden, daß die Intensität einzelner oder mehrerer vom Gitter erzeugter Beugungsmaxima gemessen wird und daß die Ergebnisse zur Steuerung des zu überwachenden Prozesses ausgewertet werden.

2. Verfahren nach Anspruch 1, dadurch gekennzeichnet, daß das Gitter im gleichen Prozeßabschnitt wie das zu entwickelnde oder zu ätzende Muster auf das Werkstück aufgebracht wird.

3. Verfahren nach den Ansprüchen 1 oder 2, dadurch gekennzeichnet, daß das Gitter an einer Stelle angebracht wird, die frei von dem zu entwickelnden oder zu ätzenden Muster ist.

4. Verfahren nach einem der Ansprüche 1 bis 3, dadurch gekennzeichnet, daß das Auftreten eines relativen Intensitätsminimums an der Stalle des Beugungsmaximums der zweiten Ordnung der am Gitter gebeugten Strahlung als Kriterium für die Beendigung des Entwicklungs- oder Ätzprozesses ausgewertet wird.

5. Verfahren nach einem der Ansprüche 1 bis 4, dadurch gekennzeichnet, daß die Gitterlinien gleiche Breiten und Abstände wie die Linien des zu entwickelnden oder zu ätzenden Musters aufweisen.

6. Verfahren nach einem der Ansprüche 1 bis 4, dadurch gekennzeichnet, daß die Gitterlinien größere Breiten und Abstände als die Linien des zu entwickelnden oder zu ätzenden Musters aufweisen.

7. Verfahren nach einem der Ansprüche 1 bis 6, dadurch gekennzeichnet, daß das Aufbringen des Gitters und der zu entwickelnden oder zu ätzenden Muster mit Hilfe von Masken erfolgt.

8. Verfahren nach einem der Ansprüche 1 bis 7, dadurch gekennzeichnet, daß das Aufbringen des Gitters und der zu entwickelnden oder zu ätzenden Muster durch Lichtstrahl- oder Elektronenstrahl- schreiber erfolgt.

9. Vorrichtung zur Steuerung von Entwicklungs- oder Ätzprozessen an einem Werkstück 6, mit einer Lichtquelle (18), dis das Werkstück mit einem parallelen monochromatischen Strahlenbündel bestrahlt, mit mindestens einem Lichtdetektor (22), der im Bereich des am Werkstück gebeugten Lichts angebracht ist und mit Verbindungsleitungen (24, 25) zu einer Auswerteschaltung (26), dadurch gekennzeichnet, daß für den Entwicklungs- oder Ätzprozeß ein Gefäß (15) vorgesehen ist, in dem ein Fenster (17) so angebracht ist, daß die Beleuchtungsstrahlung der Lichtquelle (18) auf ein am Werkstück (6) angebrachtes Gitter (G) fällt und die am Gitter gebeugte Strahlung (20, 21) durch das Fenster Wieder austritt, daß ein oder mehrer Lichtdetektoren (22, 23) jeweils so außerhalb des Gefäßes (15) angebracht sind, daß dieser oder diese die Intensität der zweiten oder der zweiten und dritten Beugungsordnung messen und daß die mit dem oder den Lichtdetektoren verbundene Auswerteschaltung (26) ein Steuersignal für den Entwicklungs- oder Ätzprozeß liefert.

**Revendications**

1. Procédé pour contrôler un processus de développement ou de décapage sur une pièce irradiée par un faisceau de lumière monochromatique parallèle, qui génère une configuration de diffraction dont on mesure l'intensité, caractérisé en ce que: en plus de la configuration qui est à développer ou à décaper, on applique à la pièce une grille latente qui peut être développée ou décapée de la même manière que la configuration, on développe ou décape la configuration et la grille ensemble, on mesure l'intensité d'une seule ou de plusieurs valeurs maximales de diffraction générées par la grille, et on évalue les résultats pour contrôler le processus à surveiller.

2. Procédé selon la revendication 1 caractérisé en ce que l'on applique la grille à la pièce pendant la même étape de procédé que la configuration à développer ou à décaper.

3. Procédé selon la revendication 1 ou 2, caractérisé en ce que l'on applique la grille à un emplacement qui est dépourvu de la configuration à développer ou à décaper.

4. Procédé selon l'une quelconques des revendications 1 à 3, caractérisé en ce que l'on considère l'apparition d'une valeur relative minimale d'intensité au point de la diffraction maximale du second ordre de la radiation diffractée à la grille comme critère pour la fin du processus de développement ou de décapage.

5. Procédé selon l'une quelconque des revendications 1 à 4, caractérisé en ce que les lignes de grille ont les mêmes largeurs et espacements que les lignes de la configuration à développer ou à décaper.

6. Procédé selon l'une quelconque des revendications 1 à 4, caractérisé en ce que les lignes de grilles ont des largeurs et des espacements plus grands que les lignes de la configuration à développer ou à décaper.

7. Procédé selon l'une quelconque des revendications 1 à 6, caractérisé en ce que l'on applique la grille et les configurations à développer ou à décaper à l'aide de masques.

8. Procédé selon l'une quelconque des revendications 1 à 7, caractérisé en ce que l'on applique la grille et les configurations à développer ou à décaper à l'aide d'un dispositif d'écriture par faisceau lumineux ou par faisceau électronique.

9. Dispositif pour contrôler le processus de développement ou de décapage sur une pièce (6) à l'aide d'une source de lumière (18) qui soumet la pièce à un faisceau monochromatique parallèle, avec au moins un détecteur de lumière (22) positionné dans la zone de la lumière diffractée par la pièce, et avec des lignes de connexion (24, 25) à un circuit d'évaluation (26), caractérisé en ce que l'on prévoit pour le processus de développement ou de décapage un récipient (15) comportant une ouverture (17) positionnée de telle sorte que le faisceau lumineux de la source de luminère (18) tombe sur une grille (G) disposée sur la pièce (6) et que la radiation (20, 21) diffractée à la grille sort à nouveau par l'ouverture, en ce que selon le cas, un ou plusieurs détecteurs de lumière (22, 23) sont disposés à l'extérieur du récipient (15) de telle sorte que le ou les détecteurs de lumière mesurent l'intensité du second ordre de diffraction ou des second et troisième ordres de diffraction, et en ce que le circuit d'évaluation (26) connecté au(x) détecteur(s) de lumière fournit un signal de contrôle pour le processus de développement ou de décapage.

## Claims

1. A method of controlling development or etch processes on a workpiece irradiated by a beam of parallel monochromatic light to generate a diffraction pattern whose intensity is measured, characterized in that in addition to the pattern to be developed or etched, a latent grid, which can be developed or etched in the same manner as the pattern, is applied to the workpiece, that the pattern and the grid are jointly developed or etched, that the intensity of one or several diffraction maxima generated by the grid is measured, and that the results are evaluated for controlling the process to be monitored.

2. The method according to claim 1, characterized in that the grid is applied to the workpiece in the same process step as the pattern to be developed or etched.

3. The method according to claim 1 or 2, characterized in that the grid is applied to an area which is free from the pattern to be developed or etched.

4. The method according to any one of the claims 1 to 3, characterized in that the occurrence of a relative intensity minimum at the point of the diffraction maximum of the second order of the radiation diffracted at the grid is taken as a criterion for the end of the development or etch process.

5. The method according to any one of the claims 1 to 4, characterized in that the grid lines have the same widths and spacings as the lines of the pattern to be developed or etched.

6. The method according to any one of the claims 1 to 4, characterized in that the grid lines have greater widths and spacings than the lines of the pattern to be developed or etched.

7. The method according to any one of claims 1 to 6, characterized in that the grid and the patterns to be developed or etched are applied by means of masks.

8. The method according to any one of the claims 1 to 7, characterized in that the grid and the patterns to be developed or etched are applied by means of a light beam or an electron beam recorder.

9. An arrangement for controlling development or etch processes on a workpiece (6) by means of a light source (18) subjecting the workpiece to a parallel monochromatic beam, with at least one light detector (22) positioned in the area of the light diffracted at the workpiece and with connecting lines (24, 25) to an evaluator circuit (26), characterized in that for the development or etch process a vessel (15) is provided in which a window (17) is so positioned that the illuminating radiation of the light source (18) is incident on a grid (G) arranged on the workpiece (6), and the radiation (20, 21) diffracted at the grid exits through the window, that one or several light detectors (22, 23) are so arranged outside the vessel (15) that the light detector or light detectors measure the intensity of the second or the second and the third diffraction order, and that the evaluator circuit (26) connected to the light detector or the light detectors supplies a control signal for the development or the etch process.

**0 000 170**

FIG.1

$b = \frac{g}{2}$

FIG.4

FIG.2

FIG.3